# EUROPÄISCHE PATENTSCHRIFT

(11) **EP 0 839 390 B1**
(45) Veröffentlichungstag und Bekanntmachung des Hinweises auf die Patenterteilung: **28.04.1999**
(21) Anmeldenummer: 96922752.9
(22) Anmeldetag: 08.07.1996
(51) Int. Cl.: H01L 29/788, G11C 16/04

(54) **ELEKTRISCH LÖSCH- UND PROGRAMMIERBARE NICHT-FLÜCHTIGE SPEICHERZELLE**
ELECTRICALLY ERASABLE AND PROGRAMMABLE NON-VOLATILE STORAGE LOCATION
CELLULE DE MEMOIRE REMANENTE EFFA ABLE ET PROGRAMMABLE ELECTRIQUEMENT

(30) Priorität: 17.07.1995 DE 19526012
(43) Veröffentlichungstag der Anmeldung: 06.05.1998
(73) Patentinhaber: SIEMENS AKTIENGESELLSCHAFT, 80333 München (DE)
(72) Erfinder: TEMPEL, Georg, D-81927 München (DE); WINNERL, Josef, D-81929 München (DE)
(86) Internationale Anmeldenummer: DE9601226
(87) Internationale Veröffentlichungsnummer: WO9704490

(56) Entgegenhaltungen:
- EP-A- 0 551 728
- EP-A- 0 558 404
- EP-A- 0 618 586
- US-A- 5 294 819
- PATENT ABSTRACTS OF JAPAN vol. 15, no. 241 (E-1080), 21.Juni 1991 & JP,A,03 074881 (HITACHI LTD), 29.März 1991,

## Beschreibung

Microcontroller benötigen bei Anwendungen für allgemeine Steueraufgaben insbesondere aber in Chipkarten nicht-flüchtige Speicher als Programmspeicher und Datenspeicher. Vor allem bei der Anwendung in tragbaren Datenträgern mit Batteriebetrieb, wie bei mobiler Datenübertragung und Datenverarbeitung, oder mit drahtloser Energiezuführung, wie bei kontaktlosen Chipkarten, sind insbesondere für den Datenspeicher nur Programmier- und Löschverfahren mit geringem Leistungsverbrauch akzeptabel. In gleicher Weise sollten die Versorgungsspannungen weniger als 3 V betragen. Da Controller und Chipkarten einem hohen Preisdruck unterliegen ist für eine breite Anwendung eine geringe Herstellprozeßkomplexität der nicht-flüchtigen Speicher wichtig.

Die bei Chipkarten heute weitgehend verwendeten FLOTOX-EEPROM-Zellen, wie sie beispielsweise aus "Mikroelektronische Speicher" von Dietrich Rhein und Heinz Freitag, Springer-Verlag Wien, 1992, insbesondere Seite 122 bekannt sind, zeichnen sich durch geringen Leistungsverbrauch aus, da sie über Fowler-Nordheim-Tunnelströme programmiert und gelöscht werden. Dadurch lassen sich die Programmierspannungen einfach auf dem Chip auch aus niedrigen Versorgungsspannungen, die kleiner als 3 V sein können, erzeugen. Die Umprogrammierung ist bei solchen Speichern byteweise möglich, so daß sich FLOTOX-EEPROM-Zellen besonders für Datenspeicher eignen, die im Betrieb umprogrammiert werden. Diese FLOTOX-EEPROM-Zellen bestehen aus einem Auswahl- und einem Speichertransistor und benötigen deshalb eine große Zellfläche, so daß auf einem Chip nur kleine Speicher realisierbar sind. Außerdem ist durch die erforderliche hohe Programmierspannung von 15 bis 20 V die Realisierung der Hochvolttransistoren, um diese Programmierspannung schalten zu können, aufwendig.

Flash-Speicher sind im Gegensatz zu EEPROMs mit nur einem Transistor pro Speicherzelle realisiert, so daß hier deutlich komplexere Speicher als mit FLOTOX-EEPROM-Zellen möglich sind. Allerdings werden sie mit heißen Ladungsträgern (channel hot electron: CHE) programmiert. Diese Art der Programmierung erfordert hohe Programmierströme, die die minimale Versorgungsspannung auf ca. 5 V begrenzen. Sie sind deshalb als Datenspeicher, die im Betrieb aus geringen Versorgungsspannungen oder über kontaktlose Energiezuführung umprogrammiert werden sollen, nicht verwendbar. Eine heute übliche Split-Gate-Flash-EEPROM-Zelle ist ebenfalls in dem Buch "Mikroelektronische Speicher" auf Seite 126 dargestellt und beschrieben.

Auch die US-5,294,819 zeigt eine Ein-Transistor-EEPROM-Zelle, die mit nur einem durch einen Source-Kanal-Drain-Übergang gebildeten MOS-Transistor gebildet ist, bei dem in einem Halbleitersubstrat eines ersten Leitfähigkeitstyps ein Drain- und ein Sourcebereich eines zweiten Leitungstyps mit zum ersten Leitfähigkeitstyp entgegengesetzter Polarität ausgebildet sind. Die Zelle weist eine sich auf schwebendem Potential befindende Gateelektrode auf, die vom Draingebiet durch ein Tunneloxid und von einer sich zwischen dem Drain- und dem Sourcegebiet befindenden Kanalbereich durch ein Gateoxid elektrisch isoliert ist und sich in Source-Kanal-Drain-Richtung zumindest über einen Teil des Kanalbereichs und einen Teil des Drainbereichs erstreckt sowie eine Steuerelektrode, die durch ein Koppeloxid von der Gateelektrode elektrisch isoliert ist.

Dort werden sowohl das Löschen als auch das Programmieren mittels Tunnelströme durchgeführt, allerdings wird lediglich eine hohe positive Spannung benutzt, die entweder an das Steuergate oder den Drainanschluß des Transistors angelegt wird, um Elektronen auf das Steuergate zu bringen oder wegzu nehmen. Durch die Verwendung von nur einer hohen positiven Spannung muß diese einen großen Betrag von etwa 18 Volt haben, wodurch ein großer Aufwand für Isolation auf dem Halbleiterchip getrieben werden muß.

Die Patent Abstracts of Japan, Vol. 15, No. 241 und die JP-A-3 074 881 zeigen ebenfalls eine nichtflüchtige Speicherzelle mit dem oben beschriebenen Aufbau. Dort wird an das Steuergate eine negative Spannung und eine geringe Spannung an die Drainelektrode angelegt, um Elektronen vom Speichergate zu entfernen. Es ist jedoch nicht offenbart, wie die Elektronen auf das Speichergate gebracht werden.

Es ist somit die Aufgabe vorliegender Erfindung, ein Verfahren zum Betreiben einer elektrisch lösch- und programmierbaren nichtflüchtigen Speicherzelle anzugeben, das die Nachteile des Standes der Technik vermeidet.

Die Erfindung wird durch ein Verfahren mit den Merkmalen des Anspruchs 1 gelöst. Vorteilhafte Weiterbildungen sind in den Unteransprüchen angegeben.

Die der Erfindung zugrunde liegende Speicherzelle besteht aus nur einem Transistor, so daß ihr Platzbedarf gegenüber herkömmlichen FLOTOX-EEPROM-Zellen deutlich geringer ist. Sie wird jedoch in gleicher Weise wie solche FLOTOX-EEPROM-Zellen durch Fowler-Nordheim-Tunnelströme programmiert und gelöscht.

Durch die erfindungsgemäße Verwendung von negativen und positiven Spannungen zum Programmieren und Löschen kann jedoch der Betrag der Hochspannungen relativ gering gehalten werden, so daß auch die Nicht-Hochvolt-Schaltungsteile weniger spannungsfest sein müssen und damit mit weniger Fertigungsaufwand hergestellt werden können. Außerdem kann die zur Erzeugung der Hochspannung nötige On-Chip-Ladungspumpe kleiner dimensioniert werden.

Wenn der erste Leitfähigkeitstyp der p-leitende Typ ist, es sich bei dem die Zelle bildenden MOS-Transistor um einen n-Kanal-Transistor handelt, wird die Zelle typischerweise dadurch programmiert, daß an ihr Steuergate eine Spannung von -12 V und an die Drain eine Spannung von +5 V angelegt wird, während die Source mit Masse verbunden ist. Dadurch tunneln im Bereich des Tunneloxids, also in dem Bereich, in dem die sich auf schwebendem Potential befindende Gate-Elektrode, das sogenannte Floating-Gate mit dem Drainbereich überlappt, Ladungsträger durch das Tunneloxid, so daß sich das Floating-Gate positiv auflädt. Dadurch verschiebt sich die Einsatzspannung dieses MOS-Transistors zu niedrigeren Werten. Zum Löschen einer solchermaßen programmierten Zelle wird an die Steuer-Elektrode eine Spannung von typischerweise 12 V und an die Source-Elektrode eine Spannung von typischerweise -6 V angelegt, während die Drain-Elektrode offen bleibt. Dadurch tunneln Ladungsträger zwischen dem Floating-Gate und dem Source- und auch Kanalbereich, so daß das Floating-Gate wieder entladen wird und sich die Einsatzspannung des Transistors zu höheren Werten hin verschiebt. Die Einsatzspannungen liegen bei einer programmierten Zelle bei etwa 1 V und bei einer nicht programmierten Zelle bei etwa 5 V. Zum Lesen wird deshalb an das Steuergate eine Spannung von etwa 3 V angelegt, während an der Drain eine Spannung von etwa 1 V und an der Source eine Spannung von 0 V angelegt ist. Nur bei einer programmierten Zelle wird dann ein Strom fließen, der beispielsweise als logische "1" detektiert werden kann.

Durch die erfindungsgemäße gleichzeitige Verwendung einer positiven und einer negativen Spannung zum Programmieren und Löschen einer erfindungsgemäßen Speicherzelle ist es möglich, auf einen zusätzlichen, einen hohen Platzbedarf erfordernden Auswahltransistor zu verzichten und trotzdem jede Speicherzelle einzeln adressieren zu können. Bei einer herkömmlichen Anordnung der Speicherzellen in einer Speichermatrix, bei der die Gateanschlüsse der Speicherzellen mit den Wortleitungen und die Drainanschlüsse mit den Bitleitungen verbunden sind, sind beim Anlegen einer negativen Spannung an eine Wortleitung zwangsläufig alle Speicherzellen, deren Gateanschlüsse mit dieser Wortleitung verbunden sind, mit dieser negativen Spannung verbunden. Es wird aber nur diejenige Speicherzelle programmiert, deren Drainanschluß mit einer positiven Spannung verbunden ist. Die Bedingung, daß beide Spannungen gleichzeitig nur an einer einzigen Speicherzelle anliegen, kann somit durch Auswahl nur einer Wortleitung und nur einer Bitleitung erfüllt werden.

Bei der erfindungsgemäß verwendeten Speicherzelle liegt am Drain-maximal die Versorgungsspannung an, so daß auch an der Bitleitung, die mit dem Drain-Anschluß verbunden ist und damit an den Auswerteschaltungen maximal die Versorgungsspannung anliegt und somit keine speziellen Vorkehrungen zum Schutz dieser Auswerteschaltungen getroffen werden müssen.

Die erfindungsgmäß verwendeten Speicherzelle kann in vorteilhafter Weise zusammen mit Standard-CMOS-Logikschaltungen auf einem Halbleitersubstrat, also auf einem Chip realisiert werden. Außerdem ist es möglich, gleichzeitig auch die Hochvolt-CMOS-Schaltkreise zum Schalten der erforderlichen positiven und negativen Hochspannungen auf demselben Halbleitersubstrat zu realisieren. Sowohl die Speicherzellen als auch die Hochvoltschaltungen werden zu diesem Zweck in tiefen Wannen mit einer Polarität des Leitfähigkeitstyps, die zur Polarität des Leitfähigkeitstyps des Halbleitersubstrats entgegengesetzt ist, angeordnet.

Bei einer ersten Ausbildung einer erfindungsgemäß verwendeten Speicherzelle erstreckt sich das Floating Gate in Source-Kanal-Drain-Richtung über den gesamten Kanalbereich und noch über einen Teil des Drainbereichs. Dieser Überlappbereich Floating-Gate - Drain definiert hier den Tunnelbereich beim Programmieren.

In einer besonders vorteilhaften Ausbildung ist das isolierende Oxid zumindest in einem Teil des Überlappbereichs dünner als über dem Kanalbereich. Durch diesen dünneren Bereich wird dann der Tunnelbereich definiert. Um Gatefeld-induzierte Drainleckströme beim Programmieren zu vermeiden ist es jedoch besonders vorteilhaft, wenn im Bereich des pn-Übergangs vom Drainbereich zum Kanalbereich das Oxid dicker ist als das Tunneloxid.

Bei Speicherzellen, bei denen das Floating-Gate den gesamten Kanalbereich überdeckt wird bei zu langem Programmieren die Einsatzspannung der Zelle negativ, so daß ein Deselektieren solcher programmierter Zellen beim Lesen verhindert wird. Dies kann durch die vorteilhafte Ausbildung einer sogenannten Split-Gate-Zelle verhindert werden. Dabei erstreckt sich das Floating-Gate nur über einen Teil des Kanalbereichs, während sich die Steuerelektrode über den gesamten Kanalbereich erstreckt und dabei im Bereich, wo kein Floating-Gate mehr ist, kapazitiv an den Kanal zu dessen Steuerung ankoppelt. Mit einer solchen Split-Gate-Zelle wird über den aus Steuerelektrode und Gateoxid gebildeten Serientransistor die untere Einsatzspannung der Zelle begrenzt, selbst wenn die Einsatzspannung des Transistorteils aus Floating-Gate und Gateoxid negativ wird.

Die Erfindung soll nachfolgend anhand eines Ausführungsbeispiels mit Hilfe von Figuren näher erläutert werden. Dabei zeigen:
Figur 1 in schematischer Darstellung einen Querschnitt durch eine erfindungsgemäß verwendeten Speicherzelle,
Figur 2 in schematischer Darstellung einen Querschnitt durch eine Weiterbildung der erfindungsgemäß verwendeten Speicherzelle,
Figur 3 in schematischer Darstellung die Anordnung solcher Speicherzellen in einer Speicherzellen-Matrix und
Figur 4 in schematischer Form die prinzipielle Realisierung von Speicherfeld, Standard-CMOS-Logik und Hochvolt-CMOS-Schaltungen in einem Halbleitersubstrat.

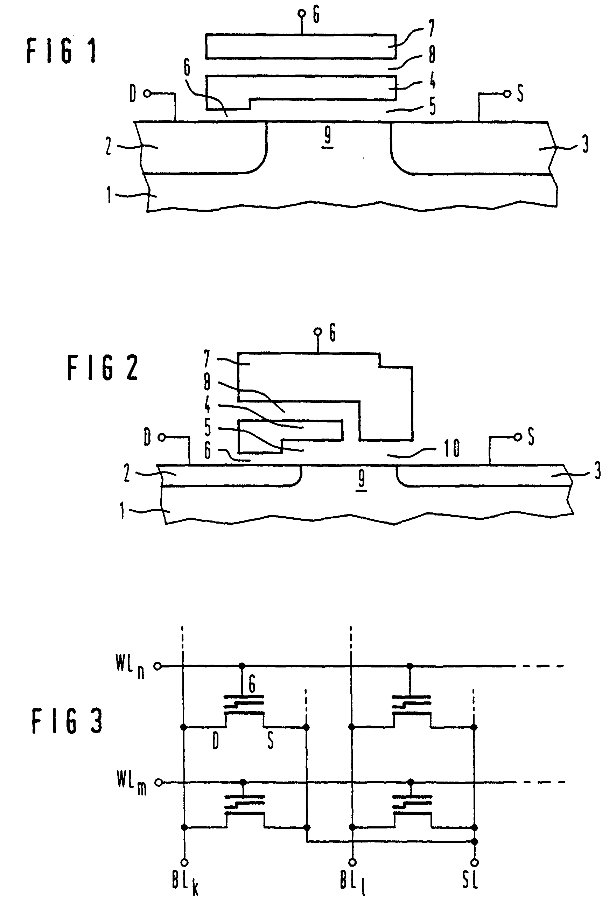

Figur 1 zeigt ein Halbleitersubstrat 1, von einem ersten Leitfähigkeitstyp, der beispielsweise vom p-Typ sein soll. Darin sind ein Drainbereich 2 und ein Sourcebereich 3 von einem Leitfähigkeitstyp mit zum Leitfähigkeitstyp des Halbleitersubstrats 1 entgegengesetzter Polarität, im vorliegenden Beispiel also vom n-Typ. Entsprechend handelt es sich beim Transistor dieser Speicherzelle um einen n-Kanal-Transistor. Der Drainbereich 2 ist mit einem Drainanschluß D und der Sourcebereich 3 mit einem Sourceanschluß S versehen. Über dem Drainbereich 2 und dem Sourcebereich 3 und dem sich zwischen diesen Bereichen befindenden Kanalbereich 9 ist eine Oxidschicht als elektrische Isolierschicht ausgebildet. Über dieser Oxidschicht 5, 6 ist eine Gate-Elektrode 4 ausgebildet, die sich auf elektrisch schwebendem Potential befindet. Sie wird üblicherweise als Floating-Gate bezeichnet. Sie erstreckt sich in erfindungsgemäßer Weise in Source-Kanal-Drain-Richtung des MOS-Transistors über den Kanalbereich und zumindest einen Teil des Drainbereichs 2. Der Bereich der Oxidschicht zwischen dem Floating-Gate 4 und dem Kanalbereich wird als Gateoxid 5 und der Bereich der Oxidschicht zwischen dem Floating-Gate 4 und dem Drainbereich 2 wird als Tunneloxid 6 bezeichnet. Bei der in Figur 1 dargestellten Weiterbildung der Erfindung hat das Tunneloxid 6 eine geringere Dicke als das Gateoxid 5. Besonders vorteilhaft ist es, wenn das Tunneloxid 6, wie in Figur 1 dargestellt, im Bereich des pn-Übergangs vom Draingebiet 2 zum Kanalgebiet 9 dieselbe Dicke aufweist wie das Gateoxid 5, wodurch ein Gatefeld-induzierter Drainleckstrom verhindert oder zumindest vermindert wird. Für Anwendungen, bei denen ein höherer solcher Drainleckstrom beim Programmieren akzeptiert werden kann, läßt sich die Anordnung in Figur 1 dadurch vereinfachen, daß die Dicken des Tunneloxids 6 und des Gateoxids 5 gleich gewählt werden. Für diese vereinfachte Speicherzelle entfallen im Herstellverfahren einige Prozeßschritte. Über der Gate-Elektrode bzw. dem Floating-Gate 4 ist eine durch ein Koppeloxid 8 elektrisch von dem Floating-Gate 4 isolierte Steuerelektrode 7 angeordnet. Diese ist mit einem Gateanschluß G verbunden.

Figur 2 zeigt eine Weiterbildung der Speicherzelle gemäß Figur 1, wobei gleiche Teile gleiche Bezugszeichen haben. Es ist eine Split-Gate-Zelle dargestellt. Hierbei erstreckt sich das Floating-Gate 4 nur über einen Teil des Kanalbereichs 9. Dadurch kann die Steuerelektrode 7 über einen Teilbereich 10 des Gateoxids kapazitiv an den Kanalbereich 9 ankoppeln und diesen dadurch steuern. Durch diese Maßnahme wird die Wirkung der negativen Einsatzspannung beim "Überprogramnieren" kompensiert.

Figur 3 zeigt eine schematische Darstellung erfindungsgemäßer Speicherzellen in einer Speicherzellen-Matrix. Die Speicherzellen-Matrix ist in Wortleitungen ...WLₙ, WLₘ... und Bitleitungen ...BLₖ, BLₗ... organisiert. Die Speicherzellen sind jeweils mit ihrem Gateanschluß G mit einer der Wortleitungen ...WLₙ, WLₘ... und mit ihrem Drainanschluß D mit einer der Bitleitungen ...BLₖ, BLₗ... verbunden. Die Sourceanschlüsse S aller Speicherzellen sind mit einer Sourceleitung SL verbunden. Es können natürlich auch mehrere Sourceleitungen vorhanden sein, die dann jeweils nur mit einer Gruppe von Speicherzellen-Sourceanschlüssen S verbunden sind.

Bei einer mit einem NMOS-Transistor gebildeten Speicherzelle muß zum Programmieren eine hohe negative Programmierspannung an die Steuerelektrode, also an den Gateanschluß G der Speicherzelle angelegt werden. Gemäß Figur 3 bedeutet dies, daß an eine Wortleitung WLₙ diese Programmierspannung angelegt werden muß. Das bedeutet aber, daß gleichzeitig an allen anderen Speicherzellen, deren Gateanschlüsse mit dieser Wortleitung verbunden sind, diese Programmierspannung anliegt.

Damit bei einer erfindungsgemäß verwendeten Speicherzelle jedoch tatsächlich eine Programmierung stattfindet, muß gleichzeitig zu der hohen negativen Programmierspannung am Gateanschluß G eine positive Spannung an den Drainanschluß D angelegt werden. Wie wiederum Figur 3 zu entnehmen ist, muß diese positive Spannung an eine Bitleitung BLₖ angelegt werden, wodurch wiederum diese positive Spannung an allen Drainanschlüssen D der mit dieser Bitleitung BLₖ verbundenen Speicherzellen angelegt ist. Eine Programmierung findet jedoch nur statt, wenn gleichzeitig am Gateanschluß eine negative Programmierspannung und am Drainanschluß eine positive Spannung anliegen. Wenn nur eine Wortleitung und nur eine Bitleitung ausgewählt wurden, ist diese Bedingung nur für eine einzige Speicherzelle erfüllt. Somit kann bei einem mit erfindungsgemäßen Speicherzellen aufgebauten Speicher jede Speicherzelle einzeln adressiert werden. Natürlich ist es auch möglich, durch Adressierung mehrerer Wortleitungen und/oder mehrerer Bitleitungen gleichzeitig mehrere Speicherzellen gleichzeitig zu programmieren.

Zum Löschen muß an dem Gateanschluß einer Speicherzelle eine hohe positive Spannung und an den Sourceanschluß eine negative Spannung angelegt werden. Wenn alle Sourceanschlüsse mit einer Sourceleitung verbunden sind, ist bei Auswahl nur einer Wortleitung, an der die hohe positive Spannung anliegt, die kleinste Anzahl der Speicherzellen, die auf einmal gelöscht werden die Anzahl von Speicherzellen, die an einer Wortleitung liegen. Durch diese Maßnahme wird der Löschvorgang erheblich beschleunigt.

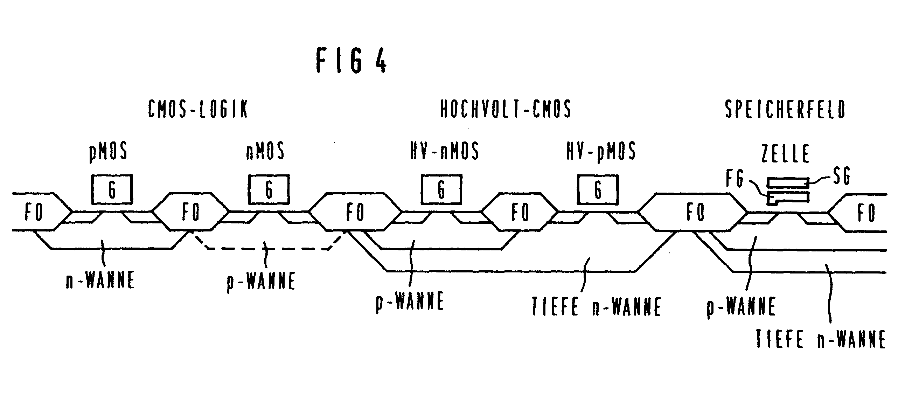

Bei der Realisierung des oben beschriebenen elektrisch lösch- und programmierbaren nicht-flüchtigen Speichers zusammen mit CMOS-Logik sind insbesondere wegen der vorkommenden hohen positiven und negativen Spannungen besondere Vorkehrungen zu treffen. Diese sind in schematischer Weise in Figur 4 dargestellt. Ausgehend von einem p-leitenden Halbleitersubstrat werden die N- und PMOS-Feldeffekttransistoren für die Logik im p-Substrat und in einer n-Wanne erzeugt. Damit ist die CMOS-Logik designkompatibel zu Standard-CMOS-Schaltungen. Für die Hochvolt-CMOS-Transistoren ist ein dickeres Gateoxid notwendig, außerdem werden die NMOS-Transistoren zum Schalten negativer Spannungen isoliert vom Substrat in eine p-Wanne innerhalb einer tiefen n-Wanne gelegt. Die Hochvolt-PMOS-Transistoren liegen in der n-Wanne. Bei nur geringen Anforderungen an die Schaltgeschwindigkeit der Logik können die Hochvolt- und Logiktransistoren auch mit der gleichen (dickeren) Oxiddicke realisiert werden. Die Speicherzellen werden isoliert vom Substrat in einer p-Wanne innerhalb einer tiefen n-Wanne erzeugt. Damit ist es möglich, eine negative Spannung an die gemeinsame Sourceleitung zu legen, ohne den Logikteil zu beinflussen.

Durch die Verwendung von positiven und negativen Spannungen ist der Betrag der auftretenden Programmierspannungen auf ca. 12 V begrenzt, so daß die Hochvoltteile nur auf diesen Betrag ausgelegt werden müssen. Durch die Verwendung der isolierten p-Wanne innerhalb der tiefen n-Wanne können negative Spannungen verarbeitet werden, ohne daß im Hochvoltteil auf Spannungsinverter oder PMOS-Sourcefolger zurückgegriffen werden muß. Im Speicherzellenfeld hat die isolierte p-Wanne den Vorteil, daß die gemeinsame Sourceleitung auf eine negative Spannung gelegt werden kann, ohne den CMOS-Logikteil dadurch zu beeinflussen. Die positiven und negativen Programmierspannungen können aufgrund des geringen Leistungsverbrauchs der Fowler-Nordheim-Programmierung leicht auf dem Chip durch Ladungspumpen erzeugt werden.

Die einzelnen Bauteile in Figur 4 sind durch Feldoxidbereiche FO voneinander getrennt. In Figur 4 sind zwar die Gate-Elektroden G der CMOS-Logik- und der Hochvolt-CMOS-Schaltungen in gleichem Abstand zum Kanalbereich dargestellt, jedoch werden in der Praxis, falls eine schnelle CMOS-Logik erforderlich ist, die Oxiddicken unter den Gate-Elektroden G unterschiedlich gewählt werden. Bei der in Figur 4 dargestellten Zelle des Speicherfelds sind das Floating-Gate FG und das Steuergate SG in schematischer Weise dargestellt.

## Patentansprüche

1. Verfahren zum Betreiben einer elektrisch lösch- und programmierbaren nicht-flüchtigen Speicherzelle, die mit nur einem durch einen Source-Kanal-Drain-Übergang gebildeten MOS-Transistor gebildet ist,
- bei dem in einem Halbleitersubstrat (1) eines ersten Leitfähigkeitstyps ein Drain- (2) und ein Sourcebereich (3) eines zweiten Leitungstyps mit zum ersten Leitfähigkeitstyp entgegengesetzter Polarität ausgebildet sind,
- mit einer sich auf schwebendem Potential befindenden Gate-Elektrode (4), die vom Draingebiet (2) durch ein Tunneloxid (5) und von einem sich zwischen dem Drain- und dem Sourcegebiet (2, 3) befindenden Kanalbereich (9) durch ein Gateoxid (5; 10) elektrisch isoliert ist und sich in Source-Kanal-Drain-Richtung zumindest über einen Teil des Kanalbereichs (9) und einen Teil des Drainbereichs (2) erstreckt und
- mit einer Steuer-Elektrode (7), die durch ein Koppeloxid (8) von der Gate-Elektrode (4) elektrisch isoliert ist,
**dadurch gekennzeichnet,** daß
- zum Programmieren der Speicherzelle an die Steuer-Elektrode (7) eine hohe negative Spannung, an die Drain-Elektrode (D) die Versorgungsspannung und an die Source-Elektrode (S) null Volt angelegt werden und
- daß zum Löschen der Speicherzelle an die Steuer-Elektrode (7) eine hohe positive Spannung und an die Source-Elektrode (S) eine negative Spannung angelegt werden und die Drain-Elektrode (D) nicht angeschlossen ist.

2. Verfahren nach Anspruch 1,
**dadurch gekennzeichnet,** daß sich die Gate-Elektrode (4) der Speicherzelle über den ganzen Kanalbereich (9) erstreckt.

3. Verfahren nach Anspruch 1,
**dadurch gekennzeichnet,** daß bei der Speicherzelle die Oxidschicht über dem Kanalbereich (9) in einen ersten Gateoxidbereich (5), der die Gate-Elektrode (4) kapazitiv an den Kanalbereich (9) koppelt und in einen zweiten
Gateoxidbereich (10) unterteilt ist,
wobei der zweite Gateoxidbereich (10) einen Teilbereich der Steuer-Elektrode (7) kapazitiv an den Kanalbereich (9) koppelt.

4. Verfahren nach einem der vorhergehenden Ansprüche,
**dadurch gekennzeichnet,** daß bei der Speicherzelle das Tunneloxid (6) dünner ist als das Gateoxid (5).

5. Verfahren nach Anspruch 4,
**dadurch gekennzeichnet,** daß sich bei der Speicherzelle das Gateoxid (5) bis in den Bereich des Übergangs vom Draingebiet (2) zum Kanalgebiet erstreckt und das Draingebiet (2) teilweise überlappt.

6. Verfahren nach einem der vorhergehenden Ansprüche,
**dadurch gekennzeichnet,** daß der MOS-Transistor in einer Wanne vom ersten Leitfähigkeitstyp ausgebildet ist, die in einer tiefen Wanne vom zweiten Leitfähigkeitstyp angeordnet ist.

7. Verfahren nach Anspruch 6,
**dadurch gekennzeichnet,** daß der MOS-Transistor zusammen mit einer Standard-CMOS-Logikschaltung und/oder einer Hochvolt-Schaltung in einem Halbleitersubstrat (1) angeordnet ist.

## Claims

1. Method for operating an electrically erasable and programmable non-volatile memory cell, which is formed with only one MOS transistor which is formed by a source-channel-drain junction,
- in which there are constructed in a semiconductor substrate (1) of a first conductivity type a drain region (2) and a source region (3) of a second conductivity type and having a polarity opposite to that of the first conductivity type,
- having a gate electrode (4) which is at a floating potential, is electrically insulated from the drain area (2) by a tunnelling oxide (5) and from a channel region (9), which is located between the drain area and the source area (2, 3), by a gate oxide (5; 10), and extends at least over a part of the channel region (9) and a part of the drain region (2) in the source-channel-drain direction, and
- having a control electrode (7) which is electrically insulated from the gate electrode (4) by a coupling oxide (8),
**characterized**
- in that, in order to program the memory cell, a high negative voltage is applied to the control electrode (7), the supply voltage is applied to the drain electrode (D) and zero volts are applied to the source electrode (S), and
- in that, in order to erase the memory cell, a high positive voltage is applied-to the control electrode (7), a negative voltage is applied to the source electrode (S), and the drain electrode (D) is not connected.

2. Method according to Claim 1,
**characterized** in that the gate electrode (4) of the memory cell extends over the entire channel region (9).

3. Method according to Claim 1,
**characterized** in that, in the memory cell, the oxide layer is divided over the channel region (9) into a first gate oxide region (5), which couples the gate electrode (4) capacitively to the channel region (9), and into a second gate oxide region (10), the second gate oxide region (10) coupling a subregion of the control electrode (7) capacitively to the channel region (9).

4. Method according to one of the preceding claims,
**characterized** in that, in the memory cell, the tunnelling oxide (6) is thinner than the gate oxide (5).

5. Method according to Claim 4,
**characterized** in that, in the memory cell, the gate oxide (5) extends into the region of the junction between the drain area (2) and the channel area, and partially overlaps the drain area (2).

6. Method according to one of the preceding claims,
**characterized** in that the MOS transistor is constructed in a well of the first conductivity type, which well is arranged in a deep well of the second conductivity type.

7. Method according to Claim 6,
**characterized** in that the MOS transistor is arranged together with a standard CMOS logic circuit and/or a high-voltage circuit in a semiconductor substrate (1).

## Revendications

1. Cellule de mémoire non volatile, programmable et effaçable électriquement, qui est formée avec un seul transistor MOS formé par une jonction source-canal-drain,
- dans laquelle, dans un substrat semi-conducteur (1) d'un premier type de conductivité, il est formé une zone de drain (2) et une zone de source (3) d'un deuxième type de conductivité ayant une polarité opposée à celle du premier type de conductivité,
- ayant une électrode de grille (4), qui se trouve à un potentiel flottant, qui est isolée électriquement de la zone de drain (2) par un oxyde de tunnel (5) et d'une zone de canal (9) se trouvant entre la zone de drain (2) et la zone de source (3) par un oxyde de grille (5 ; 10) et qui s'étend dans le sens source-canal-drain au moins au-dessus d'une partie de la zone de canal (9) et d'une partie de la zone de drain (2) et
- ayant une électrode de commande (7), qui est isolée électriquement de l'électrode de grille (4) par un oxyde de couplage (8),
**caractérisée par le fait que**
- pour programmer la cellule de mémoire, on applique une tension négative élevée à l'électrode de commande (7), la tension d'alimentation à l'électrode de drain (D) et 0 V à l'électrode de source (S) et
- pour effacer la cellule de mémoire, on applique une tension positive élevée à l'électrode de commande (7) et une tension négative à l'électrode de source (S) et l'électrode de drain (D) n'est pas raccordée.

2. Cellule de mémoire selon la revendication 1,
**caractérisée par le fait que** l'électrode de grille (4) s'étend au-dessus de toute la zone de canal (9).

3. Cellule de mémoire selon la revendication 1,
**caractérisée par le fait que** la couche d'oxyde au-dessus de la zone de canal (9) est subdivisée en une première zone d'oxyde de grille (5), qui couple de manière capacitive l'électrode de grille (4) à la zone de canal (9), et en une deuxième zone d'oxyde de grille (10), qui couple de manière capacitive une zone partielle de l'électrode de commande (7) à la zone de canal (9).

4. Procédé selon l'une des revendications précédentes,
**caractérisé par le fait que,** dans la cellule de mémoire, l'oxyde de tunnel (6) est plus mince que l'oxyde de grille (5).

5. Procédé selon la revendication 4,
**caractérisé par le fait que**, dans la cellule de mémoire, l'oxyde de grille (5) s'étend jusque dans la zone de la jonction de la zone de drain (2) à la zone de canal et chevauche en partie la zone de drain (2).

6. Procédé selon l'une des revendications précédentes,
**caractérisé par le fait que** le transistor MOS est formé dans une cuvette du premier type de conductivité, qui est disposée dans une cuvette profonde du deuxième type de conductivité.

7. Procédé selon la revendication 6,
**caractérisé par le fait que** le transistor MOS est disposé, conjointement à un circuit logique CMOS standard et/ou à un circuit haute tension, dans un substrat semi-conducteur (1).
